# EUROPÄISCHE PATENTANMELDUNG

(11) **EP 2 996 138 A1**
(43) Veröffentlichungstag der Anmeldung: **16.03.2016**
(21) Anmeldenummer: 15002973.4
(22) Anmeldetag: 04.08.2003
(51) Int. Cl.: H01J 37/05, H01J 37/147, H01J 37/26, H01J 37/28

(54) **ELEKTRONEMNMIKROSKOPIESYSTEM**

(30) Priorität: 02.08.2002 DE 10235456
(62) Teilanmeldung aus: 03017788.5
(71) Anmelder: Carl Zeiss Microscopy GmbH, 07745 Jena (DE)
(72) Erfinder: Kienzle, Oliver, 73430 Aalen (DE); Knippelmeyer, Rainer, 73431 Aalen (DE); Müller, Heiko, 69126 Heidelberg (DE)
(74) Vertreter: Diehl & Partner GbR

(57) **Zusammenfassung**

Elektronenmikroskopiesystem zur Erzeugung einer Abbildung eines in einer Objektebene (7a) anordenbaren Objekts (3a), beinhaltend:
- eine Strahlweiche (21a) zur Trennung eines Strahlengangs eines Primärelektronenstrahls (11a) von einem Strahlengang eines Sekundärelektronenstrahls (13a),
- eine Elektronenquelle (5a) zur Erzeugung des Primärelektronenstrahls (11a),
- eine im Strahlengang des Primärelektronenstrahls (11a) hinter der Strahlweiche (21a) angeordnete Objektivlinse (17a) zum Führen des Primärelektronenstrahls (11a) auf die Objektebene (7a) und zur Führung von aus einem Bereich um die Objektebene (7a) ausgehenden Sekundärelektronen als Sekundärelektronenstrahl (13a) hin zu der Strahlweiche (21a),
ferner beinhaltend einen Energieselektor (27a), welcher in dem Strahlengang des Primärelektronenstrahls (11a) zwischen der Elektronenquelle (51a) und der Strahlweiche (21a) vorgesehen ist und welcher geladene Teilchen des Primärelektronenstrahls (11a), deren kinetische Energie in einem vorbestimmten Energiebereich liegt, transmittiert und geladene Teilchen, deren kinetische Energie außerhalb des vorbestimmten Energiebereichs liegt, im Wesentlichen nicht transmittiert, wobei der Energieselektor (27a) eine Magnetpolanordnung (29a, 30a, 31a, 32a) mit einer Mehrzahl von Magnetpolpaaren aufweist, und wobei zwischen einem jeden Magnetpolpaar ein Magnetfeld zur Ablenkung der von dem Energieselektor transmittierten geladenen Teilchen bereitgestellt ist, wobei die Strahlweiche (21a) wenigstens ein Magnetpolpaar des Energieselektors (27a) umfasst, und
wobei im Strahlengang des Sekundärelektronenstrahls (13a) hinter der Strahlweiche (21a) wenigstens ein Strahlablenker (63a, 65a) oder/und wenigstens eine Quadrupollinse (61a) angeordnet ist.

## Beschreibung

Die Erfindung betrifft ein Elektronenmikroskopiesystem mit einer teilchenoptischen Vorrichtung zur Untersuchung eines Objekts, sowie ein Verfahren dazu.

Bei einem Elektronenmikroskopiesystem wird zur Untersuchung eines Objektes ein Primärelektronenstrahl auf das - zu untersuchende Objekt gerichtet, und von dem Objekt ausgehende Sekundärelektronen werden als Sekundärelektronenstrahl zu einem Detektor geführt und dort nachgewiesen. Aus einer Intensität der nachgewiesenen Sekundärelektronen kann eine Abbildung des untersuchten Objektes generiert werden.

Im Rahmen der vorliegenden Anmeldung umfasst der Begriff "Sekundärelektronen" unter anderem auch Spiegelelektronen, welche an dem Objekt reflektierte Primärelektronen sind, die die Oberfläche des Objektes nicht ganz erreichen, sowie Rückstreuelektronen, welche von der Oberfläche des Objektes emittierte Elektronen sind, die im Wesentlichen die gleiche kinetische Energie aufweisen, wie die auf das Objekt gerichteten Primärelektronen, sowie weiter Sekundärelektronen im engeren Sinne, das heißt solche von dem Objekt emittierte Elektronen, die eine kleinere kinetische Energie aufweisen als die auf das Objekt gerichteten Primärelektronen.

Bei Elektronenmikroskopiesystemen besteht ein Bedarf danach, sowohl die Elektronen des Primärelektronenstrahls als auch die Elektronen des Sekundärelektronenstrahls hinsichtlich ihrer Energie zu selektieren bzw. die in dem jeweiligen Strahl enthaltenen Elektronen hinsichtlich ihres Energiespektrums zu formen und insbesondere auf einen auswählbaren Energiebereich zu beschränken.

Ferner besteht ein Bedarf danach, einen Strahlengang des Primärelektronenstrahls von einem Strahlengang des Sekundärelektronenstrahls zu separieren, um diese Strahlen möglichst unabhängig voneinander manipulieren zu können, wobei eine mögliche Manipulation die vorangehend genannte Energieselektion umfassen kann.

Entsprechend ist es eine Aufgabe der vorliegenden Erfindung, eine teilchenoptische Vorrichtung, insbesondere ein Elektronenmikroskopiesystem, bereitzustellen, welche vereinfacht die Funktionalität einer Strahlweiche bereitstellt, und dies insbesondere in Kombination mit einem Energieselektor.

Eine erste Variante des Systems umfasst: eine Strahlweiche mit drei Anschlüssen; ein Strahlführungssystem zum Zuführen und Abführen eines ersten und zweiten Strahls von geladenen Teilchen zu bzw. weg von der Strahlweiche, wobei einer der drei Anschlüsse der Strahlweiche sowohl für einen Austritt des ersten Strahls aus der Strahlweiche als auch für einen Eintritt des zweiten Strahls in die Strahlweiche vorgesehen ist; einen Energieselektor, welcher in einem Strahlengang des ersten oder/und des zweiten Strahls vorgesehen ist und welcher geladene Teilchen, deren kinetische Energie in einem vorbestimmten Energiebereich liegt, transmittierte und welcher geladene Teilchen, deren kinetische Energie außerhalb des vorbestimmten Energiebereiches liegt, im Wesentlichen nicht transmittiert, wobei der Energieselektor eine Magnetpolanordnung mit einer Mehrzahl von Magnetpolpaaren aufweist, wobei zwischen einem jeden Magnetpolpaar ein Magnetfeld zur Ablenkung der von dem Energieselektor transmittierten geladenen Teilchen bereitgestellt ist, und wobei die Strahlweiche wenigstens ein Magnetpolpaar des Energieselektors umfasst.

Hierdurch sind die Funktionalitäten der Strahlweiche und des Energieselektors mit einem minimalen Aufwand an teilchenoptischen Komponenten bereitgestellt.

Die teilchenoptische Vorrichtung ist hierbei nicht auf die Anwendung von Elektronen als geladene Teilchen beschränkt. Vielmehr können hier auch Ionen, Myonen oder andere geladene Teilchen eingesetzt werden. Eine bevorzugte Anwendung einer solchen teilchenoptischen Vorrichtung liegt allerdings im Bereich der Elektronenmikroskopie.

Eine zweite Variante zeichnet sich dadurch aus, dass die Strahlweiche wenigstens ein Magnetpolpaar des Energieselektors umfasst und dass ein Winkel zwischen einer Richtung des Primärelektronenstrahls vor seinem Eintritt in die Strahlweiche bzw. nach seiner Emission von der Elektronenquelle und einer Richtung des Primärelektronenstrahls bei seinem Austritt aus der Strahlweiche kleiner als 90° ist, insbesondere kleiner als 80° ist und weiter bevorzugt kleiner als 60° ist.

Auch hier hat wiederum die Kombination der Funktionalitäten des Energieselektors und der Strahlweiche große Vorteile nicht nur hinsichtlich der Einsparung von Komponenten sondern auch hinsichtlich einer Verkürzung von Längen der Strahlengänge sowohl des Primärelektronenstrahls als auch des Sekundärelektronenstrahls. Eine solche Verkürzung ist erstrebenswert, um Abbildungseigenschaften des Elektronenmikroskopiesystems zu verbessern, denn diese werden aufgrund der Coulombabstoßung zwischen den Elektronen des jeweiligen Strahls mit zunehmender Länge des Strahlengangs schlechter.

Gegenüber den von herkömmlichen Elektronenmikroskopiesystemen her bekannten Umlenkwinkeln des Primärelektronenstrahls in der Weiche hat die Reduzierung dieses Winkels auf die genannten bevorzugten Winkelbereiche in Kombination mit dem Energieselektor folgenden Vorteil: die Magnetpolanordnung des Energieselektors ist darauf ausgelegt, mit den zwischen den jeweiligen Magnetpolpaaren bereitgestellten Magnetfeldern eine möglichst große Energiedispersion für den den Energieselektor durchlaufenden Strahl bereitzustellen. Diese für den den Energieselektor durchlaufenden Strahl gewünschte möglichst große Energiedispersion ist allerdings für den mit diesem Strahl durch die Weiche in Überlagerung zu bringenden anderen Strahl im Hinblick auf eine möglichst unabhängige Überlagerung der beiden Strahlen nicht wünschenswert.

Entsprechend liegt hier der Erfindung die Idee zugrunde, die Dispersion für den anderen Strahl dadurch zu reduzieren, dass der Ablenkwinkel für diesen anderen Strahl in der Strahlweiche reduziert wird. Entsprechend ist die Strahlführungsanordnung dazu ausgelegt, den Primärelektronenstrahl unter den genannten kleineren Winkeln in die Strahlweiche einzuschießen.

Bei einer weiteren Ausführungsform sieht die Erfindung im Hinblick auf eine Einstellung der Primärelektronenenergie über einen vergleichsweise großen Energiebereich vor, dass die Strahlführungsanordnung im Strahlengang des Primärelektronenstrahls zwei mit Abstand voneinander angeordnete Strahlablenker aufweist, welche jeweils einen einstellbaren Ablenkwinkel des Primärelektronenstrahls hervorrufen. Hierdurch sind im Strahlengang des Primärelektronenstrahls zwei Freiheitsgrade für das Einschießen des Primärelektronenstrahls in die Strahlweiche bereitgestellt. Es kann nämlich zum einen ein Winkel, mit dem der Primärelektronenstrahl in die Strahlweiche eingeschossen wird, verändert werden, und es kann, im Wesentlichen unabhängig davon, ein Ort, an dem der Primärelektronenstrahl in die Strahlweiche eintritt, eingestellt werden.

Vorzugsweise ist hierzu eine Steuerung vorgesehen, welche sowohl die kinetische Energie des Primärelektronenstrahls als auch Winkel und Ort für das Eintreffen des Primärelektronenstrahls in die Strahlweiche einstellt.

Gemäß einer weiteren Variante ist vorgesehen, dass, wiederum im Hinblick auf eine Einstellbarkeit der Energie des Primärelektronenstrahls über vergleichsweise große Bereiche, in der Strahlführungsanordnung vor der Strahlweiche eine Quadrupollinse vorgesehen ist, deren Quadrupolstärke einstellbar ist. Das zwischen den Magnetpolpaaren der Strahlweiche bereitgestellte Magnetfeld hat nämlich auf den Primärelektronenstrahl auch eine Wirkung wie eine Quadrupollinse, welche, insbesondere bei sich ändernden Primärelektronenenergien, nicht einfach auf Null kompensierbar ist. Entsprechend ist zusätzlich die separate Quadrupollinse mit einstellbarer Quadrupolstärke vorgesehen, um die Quadrupolwirkung der Strahlweiche zu kompensieren.

Auch hier wird vorteilhafterweise die Einstellung der Quadrupolstärke durch eine Steuerung in Abhängigkeit von der Primärelektronenenergie vorgenommen.

Unter einem Aspekt der Erfindung ist ein Elektronenmikroskopiesystem vorgesehen, welches den Energieselektor im Strahlengang des Primärelektronenstrahls aufweist, so dass das Objekt mit im Wesentlichen monochromatischen Primärelektronen bzw. Primärelektronen mit einer kinetischen Energie aus einem vergleichsweise schmalen Energiebereich bestrahlt werden kann. Auch hier umfasst eine Strahlweiche zur Separierung des Primärelektronenstrahls von dem Sekundärelektronenstrahl ein Magnetpolpaar des Energieselektors.

Die vorangehenden vorgestellten Ausführungsformen von Elektronenmikroskopiesystemen können auf verschiedene Typen von Elektronenmikroskopen angewendet werden. Diese umfassen zum einen solche Elektronenmikroskope, bei denen der Primärelektronenstrahl ein sondenformender Strahl ist, welcher auf das Objekt an vorbestimmte Orte fein fokussiert wird, und eine Sekundärelektronenintensität integral, d. h. nicht ortsauflösend erfasst wird. Die Ortsauflösung der Abbildung wird durch die Kenntnis des Ortes auf dem Objekt gewonnen, an dem der sondenformende Pimärelektronenstrahl fokussiert ist. Diese Mikroskoptypen sind in der Fachwelt als SEM ("scanning electron microscope") bekannt. Zum anderen umfassen diese Typen Elektronenmikroskope mit einem ortsauflösenden Detektor, auf welchen ein größerer Bereich des Objekts abbildungserhaltend abgebildet wird. Dieser Bereich wird mit dem Primärelektronenstrahl im Wesentlichen gleichmäßig ausgeleuchtet. Diese Mikroskoptypen sind in der Fachwelt als LEEM ("low energy electron microscope") oder SEEM ("secondary emission electron microscope") bekannt.

Ausführungsformen der Erfindung werden nachfolgend anhand von Figuren näher erläutert. Hierbei zeigt:
- Figur 1: eine erste Variante des Elektronenmikroskopiesystems in schematischer Darstellung;
- Figur 2: eine schematische Darstellung eines Strahlengangs durch eine Strahlweiche in dem Elektronenmikroskopiesystem der Figur 1;
- Figur 3: eine Schnittdarstellung der Strahlweiche der Figur 2; und
- Figur 4: eine Ausführungsform eines erfindungsgemäßen Elektronenmikroskopiesystems in schematischer Darstellung.

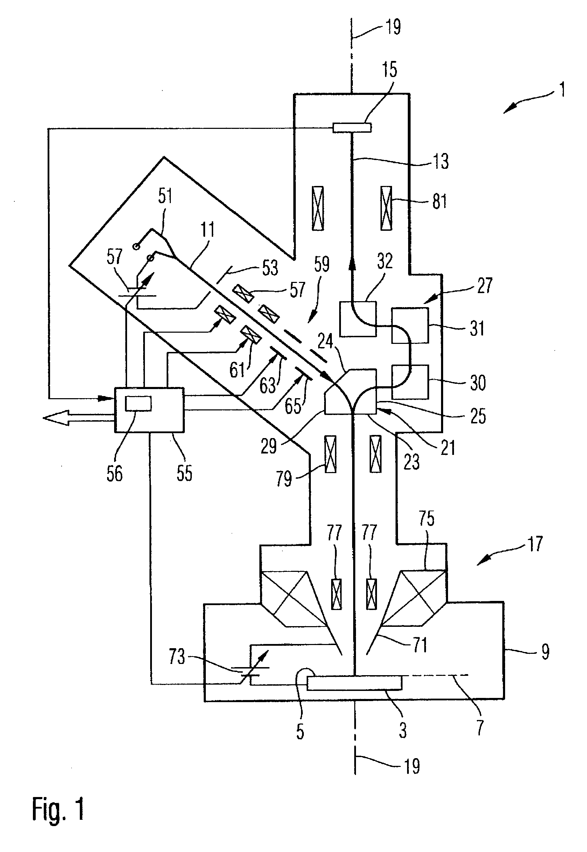

Ein in Figur 1 schematisch dargestelltes Elektronenmikroskop 1 dient zur Erzeugung einer elektronenmikroskopischen Abbildung eines zu untersuchenden Objektes, wie etwa eines Halbleiterwafers 3. Eine Oberfläche 5 desselben ist in einer Objektebene 7 des Elektronenmikroskops 1 in einer Probenkammer 9 angeordnet. Auf die Oberfläche 5 des Halbleiterwafers 3 richtet das Elektronenmikroskop 1 einen Primärelektronenstrahl 11, und von einem Bereich um die Objektebene 7 ausgehende Sekundärelektronen werden als Sekundärelektronenstrahl 13 auf einen Detektor 15 des Elektronenmikroskops 1 geleitet. Die dort registrierten Intensitäten an Sekundärelektronen liefern die Bildinformation für die zu erzeugende Abbildung des Objekts 3.

Eine Objektivanordnung 17 ist vorgesehen, um zum einen den Primärelektronenstrahl 11 auf die Oberfläche 5 des Wafers 3 zu richten, und um zum anderen die von dem Wafer 3 ausgehenden Sekundärelektronen einzufangen und zu dem Sekundärelektronenstrahl 13 zu formen. Die Objektivanordnung 17 ist bezüglich einer optischen Achse 19 derselben im Wesentlichen rotationssymmetrisch aufgebaut. Ferner überlagern sich die Strahlengänge des Primärelektronenstrahls 11 und des Sekundärelektronenstrahls 13 beim Durchsetzen der Objektivanordnung 17. Eine Strahlweiche 21 ist vorgesehen, um die in Figur 1 oberhalb der Strahlweiche 21 voneinander separierten Strahlengänge des Primärelektronenstrahls 11 und des Sekundärelektronenstrahls 13 derart umzulenken, so dass sie in einem Bereich zwischen der Strahlweiche 21 und der Objektebene 7 überlagert sind. Überlagert sind die beiden Strahlen hier in dem Sinne, dass nicht unbedingt die Strahlquerschnitte des Primärelektronenstrahls 11 und des Sekundärelektronenstrahls 13 in dem Überlagerungsbereich sich immer zwingend exakt decken. Es ist vielmehr ein gewisser Versatz der beiden Strahlquerschnitte relativ zueinander möglich. Allerdings verlaufen die beiden Strahlen in dem Überlagerungsbereich im Wesentlichen parallel zueinander und treten aus einem einzigen Anschluss 23 der Strahlweiche 21 aus bzw. in diese ein.

Die Strahlweiche 21 hat ferner zwei weitere voneinander verschiedene Anschlüsse 24 und 25 derart, dass in den Anschluss 24 der Primärelektronenstrahl 11 eintritt und aus dem Anschluss 25 der Sekundärelektronenstrahl 13 austritt.

Im Strahlengang des Sekundärelektronstrahls 13 ist ein Energieselektor 27 vorgesehen, um eine kinetische Energie von Sekundärelektronen aus dem Sekundärelektronenstrahl 13 auszuwählen. Lediglich Sekundärelektronen aus dem ausgewählten Energiebereich können den Energieselektor 27 passieren und auf den Detektor 15 treffen.

Der Energieselektor 27 ist ein Energieselektor vom sogenannten Ω-Typ, wie er beispielsweise aus US 4,740,704 bekannt ist, deren Offenbarung vollumfänglich durch Inbezugnahme in die vorliegende Anmeldung aufgenommen wird.

Ein solcher Energieselektor umfasst vier Feldbereiche 29, 30, 31 und 32, deren Umrisse in Figur 1 schematisch dargestellt sind und welche der Sekundärelektronenstrahl 13 der Reihe nach durchläuft. Der erste Feldbereich 29 lenkt den Sekundärelektronenstrahl um 90° nach rechts ab, daraufhin tritt er in den Feldbereich 30 ein, welcher ihn um 90° nach links ablenkt, worauf er in den Feldbereich 31 eintritt, der ihn um weitere 90° nach links ablenkt, woraufhin der Sekundärelektronenstrahl 13 schließlich in den Feldbereich 32 eintritt, der ihn wiederum um 90° nach rechts ablenkt. Die in den Feldbereichen 29 bis 32 vorherrschenden Magnetfeldstärken und die räumlichen Ausdehnungen der Feldbereiche sowie deren relative Anordnung zueinander ist so ausgewählt, dass der Sekundärelektronenstrahl den Energieselektor 27 im Wesentlichen gradlinig, d. h. im Wesentlichen entlang der optischen Achse 19 der Objektivanordnung 17 durchsetzt.

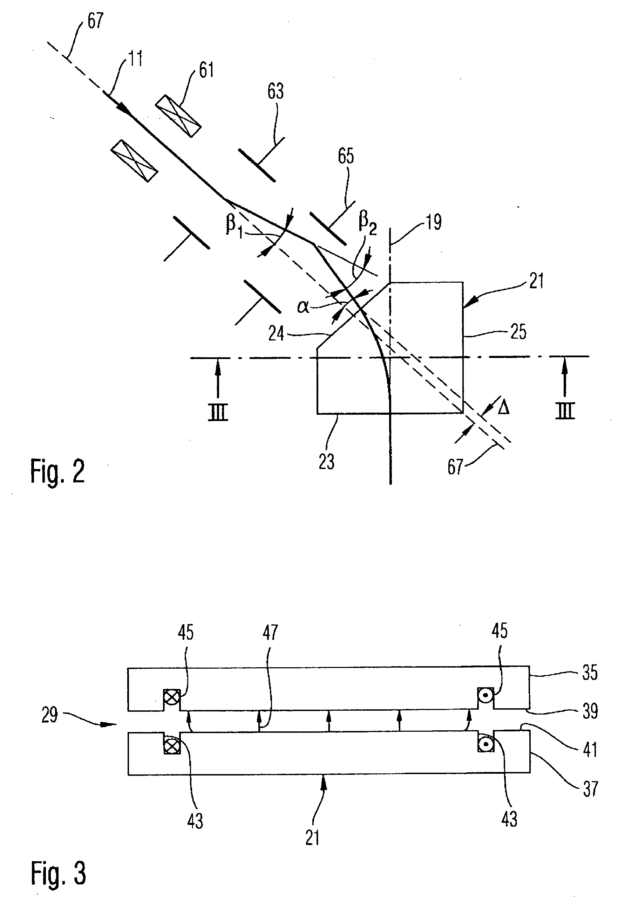

Die Feldbereiche 29 bis 32 werden jeweils durch ein Magnetpolpaar bereitgestellt, wie dies anhand der Figur 3 für den Feldbereich 29 schematisch in einer Schnittdarstellung erläutert ist. Zwei Magnetpole 35, 37 weisen aufeinander zuweisende Planflächen 39 bzw. 41 auf, in welche ringförmig geschlossene Nuten 43 eingebracht sind, in welchen wiederum Stromleiter 45 eingelegt sind. Die Nuten 43 bzw. die darin eingelegten Stromleiter 45 verlaufen entlang des Umrisses des Feldbereichs 29 und sind von einem Strom durchflossen, um zwischen den mit Abstand voneinander angeordneten zueinander zuweisenden Planflächen 39, 41 ein Magnetfeld zu erzeugen, welches in Figur schematisch durch Pfeile 47 angedeutet ist. Zwischen den Umrissen der Feldbereiche ist das Feld im Wesentlichen homogen, an den Rändern des Feldbereiches 29 treten gewisse Inhomogenitäten des Magnetfeldes auf. Der Primär- bzw. der Sekundärelektronenstrahl durchsetzen den Spalt zwischen den beiden Planflächen 39, 41 im Wesentlichen mittig und werden durch das Magnetfeld 47 abgelenkt.

Der Feldbereich 29 des Energieselektors 27 stellt, neben dem ersten Ablenkfeld für den Sekundärelektronenstrahl 13 in dem Energieselektor 27 ebenfalls das Magnetfeld der Strahlweiche 21 bereit, um den Primärelektronenstrahl 11 in Überlagerung mit dem Sekundärelektronenstrahl 13 zu bringen.

Der Primärelektronenstrahl 11 wird durch eine in der Ausführungsform als Glühkathode ausgeführte Elektronenquelle 51 erzeugt, welcher eine Anode 53 mit einer Aperturblende zur Formung des Primärelektronenstrahls 1-1 gegenüberliegt. Zwischen der Kathode 51 und der Anode 53 ist eine durch eine Steuerung 55 einstellbare Spannung 57 angelegt, um die Elektronen des Primärelektronenstrahls 11 auf eine einstellbare kinetische Energie zu bringen.

Nach Durchlaufen der Aperturblende 53 wird der Primärelektronenstrahl 11 durch eine Kollimationslinse 57 kollimiert und läuft entlang einer Achse 67 in eine Richtung weiter, welche unter einem Winkel von etwa 45° zur optischen Achse 19 orientiert ist. Zwischen der Kollimationslinse 57 und der Strahlweiche 21 ist eine Strahlführungsanordnung 59 vorgesehen, welche nacheinander eine Quadrupollinse 61, einen ersten Strahlablenker 63 und einen zweiten Strahlablenker 65 umfasst. Die Kollimationslinse 57, die Quadrupollinse 61 und die beiden Strahlablenker 63, 65 werden durch die Steuerung 55 angesteuert, und zwar in Abhängigkeit von der zwischen Kathode 51 und Anode 53 anliegenden Spannung 57, d. h. in Abhängigkeit von der kinetischen Energie des Primärelektronenstrahls 11.

Das Elektronenmikroskop 1 ist derart ausgelegt, dass die Größen der in den Feldbereichen 29 bis 32 des Energieselektors 27 bereitgestellten Magnetfelder unabhängig von der Energie des Primärelektronenstrahls 11 sind. Entsprechend ist die Ablenkung, die der Primärelektronenstrahl 11 in dem Feldbereich 29 des Energieselektors 27 erfährt, abhängig von der Energie des Primärelektronenstrahls. Um den Primärelektronenstrahl 11 jedoch im Wesentlichen unabhängig von dessen kinetischer Energie mit dem Sekundärelektronenstrahl 13 wie gewünscht zur Überlagerung zu bringen, werden die Strahlablenker 63, 65 von der Steuerung 55 angesteuert, um den Primärelektronenstrahl 11 energieabhängig abzulenken, wie dies anhand von Figur 2 schematisch erläutert ist: Die kinetische Energie des Primärelektronenstrahls 11 sei in einem Bereich zwischen Eₘᵢₙ = 20keV und Eₘₐₓ = 24keV änderbar, wobei eine Energie E₀ = 22keV in etwa in der Mitte des Bereichs liegt. Bei der Energie E₀ bewegt sich der Primärelektronenstrahl 11 im Wesentlichen geradlinig entlang der Achse 67 unter im Wesentlichen 45° zur optischen Achse 19 auf die Strahlweiche 21 zu. In dieser tritt er über den Anschluss 24 ein und wird um 45° abgelenkt, um die Strahlweiche 21 über den Anschluss 23 entlang der optischen Achse 19 zu verlassen.

Hat der Primärelektronenstrahl 11 die höhere Energie Eₘₐₓ, so wird der erste Strahlablenker 63 von der Steuerung derart angesteuert, dass er den Primärelektronenstrahl um einen Winkel β₁ nach links ablenkt. Daraufhin tritt der Primärelektronenstrahl 11 mit einem Versatz zu der Achse 67 in den zweiten Ablenker 65 ein, der den Primärelektronenstrahl 11 daraufhin um einen Winkel β₂ nach rechts ablenkt. Daraufhin tritt der Primärelektronenstrahl 11 mit einem Versatz Δ links zu der Achse 67 und mit einem Winkel α zu der Achse 67 in den Anschluss 24 der Strahlweiche 21 ein. Der Versatz Δ und der Winkel α sind derart gewählt, dass der Primärelektronenstrahl 11 mit der größeren Energie Eₘₐₓ um einen Winkel, der kleiner als 45° ist, derart abgelenkt wird, dass er die Weich 21 ebenfalls entlang der optischen Achse 19 verlässt.

Hat der Primärelektronenstrahl 11 die niedrigere Energie Emin, so werden die Ablenker 63 und 65 derart angesteuert, dass er durch den Ablenker 63 nach rechts abgelenkt wird, durch den Ablenker 65 nach links abgelenkt wird und mit einem Versatz rechts von der Achse 67 und wiederum unter einem Winkel zu der Achse 67 in den Anschluss 24 derart eintritt, dass er auch bei der niedrigeren Energie die Weiche 21 im Wesentlichen entlang der optischen Achse 19 verlässt. Bei Energien des Primärelektronenstrahls 11, die zwischen den Werten Eₘᵢₙ und Eₘₐₓ liegen, erfolgt die Ansteuerung der Ablenker 63,65 durch die Steuerung 55 entsprechend mit kleineren Ablenkwinkeln β₁, β₂.

Die Ablenker 63, 65 können als elektrostatische Ablenker oder als magnetische Ablenker ausgebildet sein. Wenigstens den näher an dem Energiefilter 27 bzw. der Weiche 29 angeordneten Ablenker 65 elektrostatisch auszubilden, hat den Vorteil, dass nicht etwa magnetische Streufelder des Ablenkers 65 den Energiefilter 27 bzw. die Strahlweiche 21 beeinflussen.

Da das zwischen den Magnetpolen 35, 37 bereitgestellte Magnetfeld 47 an dessen Rändern inhomogen ist und der Primärelektronenstrahl 11 unter verschiedenen Winkeln α in den Feldbereich 29 eintritt, hat der Feldbereich 29 mit seinen Randfedern auf den Primärelektronenstrahl 11 unterschiedliche Quadrupolwirkungen. Um dies zu kompensieren, ist die Quadrupollinse 61 vorgesehen. Diese wird durch die Steuerung 55 in Abhängigkeit von der Energie des Primärelektronenstrahls 11 derart angesteuert, dass sich die Quadrupolwirkungen der Quadrupollinse 61 und die Quadrupolwirkung des Feldbereiches 29 im Wesentlichen aufheben.

Zur Erreichung einer höheren Präzision können auch zwei Quadrupollinsen statt der einen Quadrupollinse 61 vorgesehen sein. Die Steuerung 45 umfasst zur Einstellung der Ablenkwinkel β₁ und β₂ sowie der Quadrupolwirkung der Quadrupollinse 61 bzw. der Quadrupolwirkungen von mehreren Quadrupollinsen einen Speicher 56, welcher für eine Mehrzahl von vorbestimmten Werten der Energie des Primärelektronenstrahls oder für hiervon abgeleitete physikalische Größen die entsprechenden Einstellungen der Ablenkwinkel β₁ und β₂ bzw. der entsprechenden abgeleiteten Erregungen der Ablenker 63 und 65 speichert, und welcher die entsprechenden Quadrupolwirkungen der Quadrupollinse 61 oder der mehreren Quadrupollinsen bzw. deren entsprechende Erregungen speichert.

Die Objektivanordnung 17 umfasst als weitere Komponenten noch eine Elektrode 71, an welche relativ zu dem Wafer 3 eine einstellbare Spannung 73 angelegt ist, um zwischen der Oberfläche 5 des Wafers 3 und der Elektroden 71 ein elektrisches Extraktionsfeld bereitzustellen, welches zum einen die Sekundärelektronen von der Objektebene 7 weg beschleunigt und zum anderen die Elektronen des Primärelektronenstrahls 11 vor Auftreffen auf die Objektoberfläche 5 verzögert.

Durch das Extraktionsfeld werden die Sekundärelektronen auf die kinetische Energie beschleunigt, mit der sie dann in den Energieselektor 27 eintreten. Somit können bei festgehaltener Einstellung des Energieselektors 27 durch ändern des Extraktionsfeldes auch die Energien der den Energieselektor 27 passierenden Sekundärelektronen ausgewählt werden, wobei sich dies auf die Energien der Sekundärelektronen unmittelbar bei Austritt aus dem Objekt bezieht.

Die Objektivanordnung 17 umfasst ferner eine magnetische Hauptspule 75 zur Erzeugung eines Magnetfeldes, welches wesentlich zu Fokussierung des Primärelektronenstrahls bzw. der Sekundärelektronen beiträgt. Innerhalb der Spule 75 sind Ablenkspulen 77 angeordnet, welche den Primärelektronenstrahl aus der optischen Achse 19 auslenken können, um einen größeren Teil der Objektoberfläche 7 abzutasten.

Zwischen der Objektivanordnung 17 und dem Energieselektor 27 ist noch eine Feldspule 79 vor dem Eintritt des Sekundärelektronenstrahls 13 in den Energieselektor 27 vorgesehen, welche unter anderem zu einer Anpassung des Strahlengangs des Sekundärelektronenstrahl 13 an eine Einstellung des Energieselektors 27 dient. Der Energieselektor 27 ist ebenfalls durch die Steuerung 55 ansteuerbar, um den Energiebereich auszuwählen, der von dem Energieselektor 27 transmittiert wird.

Zwischen dem Energieselektor 27 und dem Detektor 15 ist noch eine weitere Feldspule 81 vorgesehen.

Das Elektronenmikroskop 1 kann nun als SEM derart betrieben werden, dass der Primärelektronenstrahl 11 durch die Objektivanordnung 17 in der Objektebene 7 fein fokussiert wird und durch die Ablenkspulen 77 ausgelenkt wird, um einen Bereich der Objektebene 7 systematisch abzutasten. Der Detektor 15 ist hierbei nicht notwendigerweise ein ortsauflösender Detektor, die Ortsauflösung der Abbildung wird durch die Kenntnis der Orte erhalten, auf die der Primärelektronenstrahl 11 in der Objektebene 7 gerichtet ist. Die jeweils detektierten Sekundärelektronenintensitäten werden in der Abbildung diesen Orten zugeordnet.

Anderseits ist es auch möglich, das Elektronenmikroskop als LEEM bzw. SEEM zu betreiben. Hierbei beleuchtet der Primärelektronenstrahl 11 in der Objektebene 7 einen größeren Bereich gleichzeitig. Die Objektivanordnung 17 ist darauf optimiert, zusammen mit den übrigen Komponenten Teil einer Strahlführung für den Sekundärelektronenstrahl 13 derart zu sein, dass im Wesentlichen der von dem Primärelektronenstrahl 11 beleuchtete Bereich der Objektebene 7 auf einen flächigen Bereich des Detektors 15 abgebildet wird, wobei der Detektor 15 dann ein ortsauflösender Detektor ist.

Nachfolgend werden Varianten der anhand der Figuren 1 bis 3 erläuterten Ausführungsformen beschrieben. Darin sind Komponenten die hinsichtlich ihres Aufbaus oder/und ihrer Funktion Komponenten der Figuren 1 bis 3 entsprechen, mit den gleichen Bezugsziffern bezeichnet, denen zur Unterscheidung jedoch ein zusätzlicher Buchstabe hinzugefügt ist. Es wird hierbei dann auf die gesamte vorangehende Beschreibung Bezug genommen.

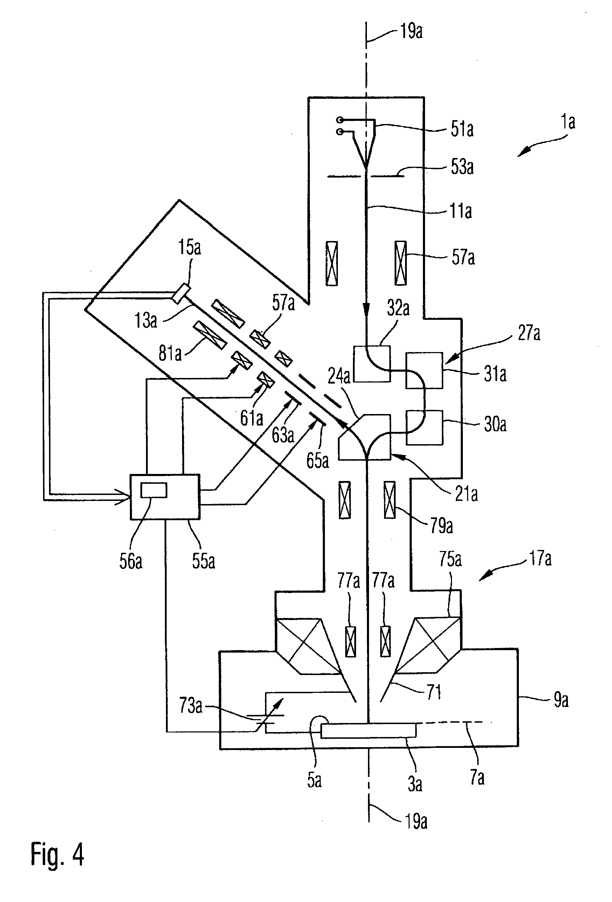

Ein in Figur 4 schematisch dargestelltes Elektronenmikroskop 1a weist eine Objektivanordnung 17a mit einer optischen Achse 19a auf. Die Objektivanordnung 17a umfasst für einen Primärelektronenstrahl 11a und einen Sekundärelektronenstrahl 13a eine fokussierende Magnetspule 75a, eine Elektrode 71a zur Bereitstellung eines Extraktionsfelds und Ablenkspulen 77a zur Ablenkung des Primärelektronenstrahls 11a bzw. des Sekundärelektronenstrahls 13a.

Im Unterschied zu dem Elektronenmikroskop der Figur 1 ist in dem Elektronenmikroskop 1a der Figur 4 ein Energieselektor 27a im Strahlengang des Primärelektronenstrahls 11aA und nicht im Strahlengang des Sekundärelektronenstrahls 13a vorgesehen.

Mit der Anordnung des Energieselektors 27a im Strahlengang des Primärelektronenstrahls ist es möglich, das Energiespektrum der Primärelektronen zu begrenzen. Einer der hierdurch erzielbaren Vorteile ist die Reduzierung eines chromatischen Abbildungsfehlers der im Strahlengang des Primärelektronenstrahls vorgesehenen optischen Komponenten, insbesondere der Objektivanordnung 17a.

Der von einer Elektronenquelle 51a emittierte und mittels einer Anodenblende 53a beschleunigte Primärelektronenstrahl 11a verläuft im Wesentlichen entlang der optischen Achse 19a und tritt nach Durchlaufen einer Kollimationslinse 57a in einen Feldbereich 32a des Energieselektors 27a ein. Durch den Feldbereich 32a wird der Primärelektronenstrahl 11a zunächst um 90° nach links, sodann durch einen weiteren Feldbereich 31a um 90° nach rechts, durch noch einen weiteren Feldbereich 30a um weitere 90° nach rechts und daraufhin durch einen Feldbereich 21a wieder um 90° nach links abgelenkt, so dass er entlang der optischen Achse 19a in die Objektivanordnung 75a nach Durchlaufen einer Feldlinse 79a eintritt.

Der Feldbereich 21a des Energieselektors 27a dient ebenfalls als Strahlweiche, um den Strahlengang des Primärelektronenstrahls 11a und des Sekundärelektronenstrahls 13a, welche zwischen der Weiche 21a und der Objektebene 7a in etwa zusammenfallen, voneinander zu separieren. Der Sekundärelektronenstrahl 13a tritt aus dem Feldbereich 21a über einen Anschluss 24a aus, durchläuft zwei Strahlablenker 65a und 63a, eine Quadrupollinse 61a und zwei weitere Linsen 57a und 81a und trifft den Detektor 15a. Die Ablenker 65a und 63a und die Quadrupollinse 61a dienen wiederum zur Anpassung der Abbildung auf den Detektor 15a an bestimmte gewünschte Energien des Sekundärelektronenstrahls 13a, ähnlich wie dies im Zusammenhang mit Figur 2 für den Primärelektronenstrahl schon beschrieben wurde. Entsprechend umfasst die Steuerung 55a einen Speicher 56a, in welchem für vorbestimmte Energien des Sekundärelektronenstrahls beim Eintritt in die Strahlweiche oder daraus abgeleitete Größen die entsprechenden Größen für die Erregungen der beiden Ablenker 63a, 65a sowie der Quadrupollinse 57a.

Mit dem Elektronenmikroskop 1a ist es möglich, durch entsprechende Ansteuerung des Energieselektors 27a die kinetische Energie der Primärelektronen auf ein gewünschtes Energieband einzustellen.

Auch das Elektronenmikroskop 1a kann als SEM oder als LEEM bzw. SEEM betrieben werden, wie dies vorangehend im Zusammenhang mit dem anhand der Figuren 1 bis 3 erläuterten Elektronenmikroskop beschrieben wurde.

Ein wesentlicher Aspekt ist hierbei die Tatsache, dass der Energiefilter an sich eine schwierig zu justierende elektronenoptische Baugruppe bildet, deren Einstellung bei geänderten Energien des in den Energiefilter eintretenden Primärelektronenstrahls aufwendig ist. Deshalb wird die Änderung der Energie der auf die Probe 3a treffenden Primärelektronen durch eine Änderung der Spannung 73a erreicht. Die Änderung der Spannung 73a ändert allerdings auch die Energie des Sekundärelektronenstrahls bei Eintritt in die Weiche 21a, so dass die hierdurch bedingten Fehler durch die energieabhängige Ansteuerung der beiden Ablenker 63a, 65a und der Quadrupollinse 61a wirksam kompensierbar sind. Insofern kann das Prinzip der Erfindung auch angewendet werden auf andere Elektronenmikroskopiesysteme mit einer Weiche, bei denen eine Energieänderung des Primärelektronenstrahls vor Eintritt in die Weiche oder des Sekundärelektronenstrahls nach Austritt aus der Weiche aufwendig oder mit einer geforderten Genauigkeit nicht möglich ist.

In den vorangehend beschriebenen Ausführungsformen weist die Objektivlinsenanordnung 17 jeweils einen rotationssymmetrischen Aufbau bezüglich der optischen Achse 19 auf, und es sind Ablenker 77 vorgesehen, um den Primärelektronenstrahl in der Objektebene 7 aus dieser optischen Achse auszulenken. Es ist allerdings auch denkbar, Objektivlinsenanordnungen einzusetzen, welche keinen rotationsymmetrischen Aufbau aufweisen. Ein Beispiel hierfür ist eine Schlitzlinse, welche zur Erzielung größerer Auslenkungen des Primärelektronenstrahls einen sich quer zur optischen Achse langgestreckten Schlitz für den Strahldurchtritt aufweist. Eine solche Linse ist in den ebenfalls anhängigen Patenanmeldungen die DE 101 31 931.2 und DE 101 61 526.4 der Anmelderin beschrieben. Die Offenbarung dieser Anmeldung wird in die vorliegende Anmeldung durch Inbezugnahme vollumfänglich aufgenommen.

In den vorangehend beschriebenen Ausführungsformen sind zwischen der Objektebene und dem Energieselektor lediglich zwei Linsen angeordnet, nämlich die Objektivlinse 17 und die Feldspule 79. Es ist jedoch möglich, zur Verbesserung der einen oder anderen optischen Eigenschaft des Gesamtsystems hier weitere Linsen bereitzustellen.

In den vorangehend beschriebenen Ausführungsformen wird lediglich ein Primärelektronenstrahl zu dem Objekt hingeführt, und es wird ebenfalls lediglich ein Sekundärelektronenstrahl von dem Objekt weg zu dem Detektor geführt. Es ist jedoch auch möglich, die vorangehend beschriebenen teilchenoptischen Komponenten auf ein Elektronenmikroskopiesystem zu übertragen, welches mehrere voneinander separierte Primärelektronenstrahlen zu dem Objekt führt oder/und welches mehrere voneinander separierte Sekundärelektronenstrahlen von dem Objekt zu ein oder mehreren Detektoren führt. Hierbei ist es möglich, dass eine oder mehrere der in den Strahlengängen vorgesehenen teilchenoptischen Komponenten jeweils als eine einzige ein magnetisches oder elektrisches Feld bereitstellende Komponente realisiert sind, wobei dann die mehreren Strahlen in das bereitgestellte Feld eintreten und in diesem gemeinsam geformt bzw. abgelenkt werden. So ist es beispielsweise möglich, durch eine Objektivanordnung mit einer zusammenhängenden Bohrung mehrere Primärelektronenstrahlen hin zu dem Objekt zu führen und diese auf dem Objekt auch zu fokussieren.

Die vorliegende Anmeldung offenbart Folgendes:
1. Ein Elektronenmikroskopiesystem zur Erzeugung einer Abbildung eines in einer Objektebene (7) anordenbaren Objekts(3), umfassend:
   - eine Strahlweiche (21) zur Trennung eines Strahlengangs eines Primärelektronenstrahls von einem Strahlengang eines Sekundärelektronenstrahls (13),
   - eine Elektronenquelle (51) zur Erzeugung des Primärelektronenstrahls (11),
   - eine Strahlführungsanordnung (59) zur Führung des Primärelektronenstrahls (11) von der Elektronenquelle (51) zu der Strahlweiche (21),
   - eine im Strahlengang des Primärelektronenstrahls (11) hinter der Strahlweiche (21) angeordnete Objektivlinse (17) zum Führen des Primärelektronenstrahls (11) auf die Objektebene (7) und zur Führung von aus einem Bereich um die Objektebene (7) ausgehenden Sekundärelektronen als Sekundärelektronenstrahl (13) hin zu der Strahlweiche (21), und
   - einen Energieselektor (27), welcher in dem Strahlengang des Sekundärelektronenstrahls (13) vorgesehen ist und welcher geladene Teilchen des Sekundärelektronenstrahls (13), deren kinetische Energie in einem vorbestimmten Energiebereich liegt, transmittiert und geladene Teilchen, deren kinetische Energie außerhalb des vorbestimmten Energiebereichs liegt, im Wesentlichen nicht transmittiert, wobei der Energieselektor (27) eine Magnetpolanordnung (29, 30, 31, 32) mit einer Mehrzahl von Magnetpolpaaren (35, 37) aufweist, und wobei zwischen einem jeden Magnetpolpaar (35, 37) ein Magnetfeld (47) zur Ablenkung der von dem Energieselektor (27) transmittierten geladenen Teilchen bereitgestellt ist,
      wobei die Strahlweiche (21) wenigstens ein Magnetpolpaar (35, 37) des Energieselektors (27) umfasst, und ein Winkel zwischen einer Richtung des Primärelektronenstrahls (11) nach seiner Emission durch die Elektronenquelle (51) und einer Richtung des Primärelektronenstrahls (11) bei seinem Austritt aus der Strahlweiche (21) kleiner als 80° ist, und insbesondere kleiner als 60° ist.
2. Das Elektronenmikroskopiesystem nach Absatz 1, wobei die Strahlweiche (21) wenigstens ein Magnetpolpaar (35, 37) des Energieselektors (27) umfasst, und wobei die Strahlführungsanordnung (59) im Strahlengang des Primärelektronenstrahls (11) zwei mit Abstand voneinander angeordnete Strahlablenker (63, 65) jeweils zur Erzeugung von einstellbaren Ablenkwinkeln (β₁, β₂) des Primärelektronenstrahls umfasst.
3. Das Elektronenmikroskopiesystem nach Absatz 2, ferner umfassend eine Energieeinstellvorrichtung (57) zur Einstellung einer kinetischen Energie der Elektronen des in die Strahlweiche (21) eintretenden Primärelektronenstrahls (11) und eine Steuerung (55) zur Ansteuerung der Energieeinstellvorrichtung (57), wobei die Steuerung (55) ferner die beiden Strahlablenker (63, 65) zur Einstellung der Ablenkwinkel (β₁, β₂) in Abhängigkeit von der eingestellten Energie ansteuert.
4. Das Elektronenmikroskopiesystem nach Absatz 3, wobei die Steuerung (55) einen Speicher (56) zur Speicherung von einander zugeordneten Werten aufweist, welche die kinetische Energie der Elektronen des in die Strahlweiche (21) eintretenden Primärelektronenstrahls und Einstellungen der beiden Strahlablenker (63, 65) repräsentieren.
5. Das Elektronenmikroskopiesystem nach einem der Absätze 1 bis 4, wobei die Strahlweiche (21) wenigstens ein Magnetpolpaar (35, 37) des Energieselektors (27) umfasst, und wobei die Strahlführungsanordnung (59) im Strahlengang des Primärelektronenstrahls (11) wenigstens eine Quadrupollinse (61) mit einstellbarer Quadrupolstärke umfasst.
6. Das Elektronenmikroskopiesystem nach Absatz 5, ferner umfassend eine Energieeinstellvörrichtung (57) zur Einstellung einer kinetischen Energie der Elektronen des in die Strahlweiche (21) eintretenden Primärelektronenstrahls (11) und eine Steuerung (55) zur Ansteuerung der Energieeinstellvorrichtung (57), wobei die Steuerung (55) ferner die Quadrupollinse (61) zur Einstellung der Quadrupolstärke in Abhängigkeit von der eingestellten Energie ansteuert.
7. Das Elektronenmikroskopiesystem nach Absatz 6, wobei die Steuerung (55) einen Speicher (56) zur Speicherung von einander zugeordneten Werten aufweist, welche die kinetische Energie der Elektronen des in die Strahlweiche (21) eintretenden Primärelektronenstrahls und eine Einstellung der Quadrupollinse (61) repräsentieren.
8. Ein Elektronenmikroskopiesystem zur Erzeugung einer Abbildung eines in einer Objektebene (7a) anordenbaren Objekts (3a), umfassend:
   - eine Strahlweiche (21 a) zur Trennung eines Strahlengangs eines Primärelektronenstrahls (11a) von einem Strahlengang eines Sekundärelektronenstrahls (13a),
   - eine Elektronenquelle (5a) zur Erzeugung des Primärelektronenstrahls (11a),
   - eine im Strahlengang des Primärelektronenstrahls (11a) hinter der Strahlweiche (21a) angeordnete Objektivlinse (17a) zum Führen des Primärelektronenstrahls (11a) auf die Objektebene (7a) und zur Führung von aus einem Bereich um die Objektebene (7a) ausgehenden Sekundärelektronen als Sekundärelektronenstrahl 813a)hin zu der Strahlweiche (21 a),
      wobei im Strahlengang des Sekundärelektronenstrahls (13a) hinter der Stahlweiche (21a) wenigstens ein Strahlablenker (63a, 65a) oder/und wenigstens eine Quadrupollinse (61a) angeordnet ist.
9. Das Elektronenmikroskopiesystem nach Absatz 8, ferner umfassend eine Energieeinstellvorrichtung (73a) zur Einstellung einer kinetischen Energie der Elektronen des in die Strahlweiche (21 a) eintretenden Sekundärelektronenstrahls (13a) und eine Steuerung (55a) zur Ansteuerung der Energieeinstellvorrichtung (73a), wobei die Steuerung (55a) den wenigstens einen Strahlablenker (63a, 65a) oder/und die wenigstens eine Quadrupollinse (61 a) in Abhängigkeit von der eingestellten Energie ansteuert.
10. Das Elektronenmikroskopiesystem nach Absatz 9, wobei die Steuerung (55a) einen Speicher (56a) zur Speicherung von einander zugeordneten Werten aufweist, welche die kinetische Energie der Elektronen des in die Strahlweiche (21a) eintretenden Sekundärelektronenstrahls und Einstellungen des wenigstens einen Strahlablenkers (63a, 65a) oder/und der wenigstens einen Quadrupollinse (61a) repräsentieren.
11. Das Elektronenmikroskopiesystem nach einem der Absätze 8 bis 10, ferner umfassend einen Energieselektor (27a), welcher in dem Strahlengang des Primärelektronenstrahls (11a) zwischen der Elektronenquelle (51a) und der Strahlweiche (21a) vorgesehen ist und welcher geladene Teilchen des Primärelektronenstrahls (11a), deren kinetische Energie in einem vorbestimmten Energiebereich liegt, transmittiert und geladene Teilchen, deren kinetische Energie außerhalb des vorbestimmten Energiebereichs liegt, im Wesentlichen nicht transmittiert, wobei der Energieselektor (27a) eine Magnetpolanordnung (29a, 30a, 31a, 32a) mit einer Mehrzahl von Magnetpolpaaren aufweist, und wobei zwischen einem jeden Magnetpolpaar ein Magnetfeld zur Ablenkung der von dem Energieselektor transmittierten geladenen Teilchen bereitgestellt ist, wobei die Strahlweiche (21a) wenigstens ein Magnetpolpaar des Energieselektors (27a) umfasst.
12. Das Elektronenmikroskopiesystem nach einem der Absätze 1 bis 11, wobei die Objektivlinse (17) dazu vorgesehen ist, den Primärelektronenstrahl in der Objektebene fein zu fokussieren.
13. Das Elektronenmikroskopiesystem nach einem der Absätze 1 bis 12, wobei die Objektivlinse (17a) Teil eines Abbildungsstrahlengangs ist, mit dem die Objektebene durch den Sekundärelektronenstrahl im Wesentlichen scharf auf einen Sekundärelektronendetektor (15a) abgebildet ist.

## Patentansprüche

1. Elektronenmikroskopiesystem zur Erzeugung einer Abbildung eines in einer Objektebene (7a) anordenbaren Objekts (3a), beinhaltend:
- eine Strahlweiche (21a) zur Trennung eines Strahlengangs eines Primärelektronenstrahls (11a) von einem Strahlengang eines Sekundärelektronenstrahls (13a),
- eine Elektronenquelle (5a) zur Erzeugung des Primärelektronenstrahls (11a),
- eine im Strahlengang des Primärelektronenstrahls (11a) hinter der Strahlweiche (21a) angeordnete Objektivlinse (17a) zum Führen des Primärelektronenstrahls (11a) auf die Objektebene (7a) und zur Führung von aus einem Bereich um die Objektebene (7a) ausgehenden Sekundärelektronen als Sekundärelektronenstrahl (13a) hin zu der Strahlweiche (21a),
ferner beinhaltend einen Energieselektor (27a), welcher in dem Strahlengang des Primärelektronenstrahls (11a) zwischen der Elektronenquelle (51a) und der Strahlweiche (21a) vorgesehen ist und welcher geladene Teilchen des Primärelektronenstrahls (11a), deren kinetische Energie in einem vorbestimmten Energiebereich liegt, transmittiert und geladene Teilchen, deren kinetische Energie außerhalb des vorbestimmten Energiebereichs liegt, im Wesentlichen nicht transmittiert, wobei der Energieselektor (27a) eine Magnetpolanordnung (29a, 30a, 31a, 32a) mit einer Mehrzahl von Magnetpolpaaren aufweist, und wobei zwischen einem jeden Magnetpolpaar ein Magnetfeld zur Ablenkung der von dem Energieselektor transmittierten geladenen Teilchen bereitgestellt ist, wobei die Strahlweiche (21a) wenigstens ein Magnetpolpaar des Energieselektors (27a) umfasst, und
wobei im Strahlengang des Sekundärelektronenstrahls (13a) hinter der Strahlweiche (21a) wenigstens ein Strahlablenker (63a, 65a) oder/und wenigstens eine Quadrupollinse (61a) angeordnet ist.

2. Elektronenmikroskopiesystem nach Anspruch 1, ferner umfassend eine Energieeinstellvorrichtung (73a) zur Einstellung einer kinetischen Energie der Elektronen des in die Strahlweiche (21a) eintretenden Sekundärelektronenstrahls (13a) und eine Steuerung (55a) zur Ansteuerung der Energieeinstellvorrichtung (73a), wobei die Steuerung (55a) den wenigstens einen Strahlablenker (63a, 65a) oder/und die wenigstens eine Quadrupollinse (61a) in Abhängigkeit von der eingestellten Energie ansteuert.

3. Elektronenmikroskopiesystem nach Anspruch 2, wobei die Steuerung (55a) einen Speicher (56a) zur Speicherung von einander zugeordneten Werten aufweist, welche die kinetische Energie der Elektronen des in die Strahlweiche (21a) eintretenden Sekundärelektronenstrahls und Einstellungen des wenigstens einen Strahlablenkers (63a, 65a) oder/und der wenigstens einen Quadrupollinse (61a) repräsentieren.

4. Elektronenmikroskopiesystem nach einem der Ansprüche 1 bis 3, wobei die Objektivlinse (17) dazu vorgesehen ist, den Primärelektronenstrahl in der Objektebene fein zu fokussieren.

5. Elektronenmikroskopiesystem nach einem der Ansprüche 1 bis 4, wobei die Objektivlinse (17a) Teil eines Abbildungsstrahlengangs ist, mit dem die Objektebene durch den Sekundärelektronenstrahl im Wesentlichen scharf auf einen Sekundärelektronendetektor (15a) abgebildet ist.

6. Elektronenmikroskopiesystem nach einem der Ansprüche 1 bis 5, wobei die Strahlweiche drei Anschlüsse hat, von denen einer sowohl für den Austritt eines ersten Strahls von geladenen Teilchen aus der Strahlweiche als auch für den Eintritt eines zweiten Strahls geladener Teilchen in die Strahlweiche dient.

7. Elektronenmikroskopieverfahren, beinhaltend:
Erzeugung eines Primärelektronenstrahls (11a) und Führen dessen in seinem Strahlengang,
Selektieren von Primärelektronen eines vorbestimmten Energiebereichs durch Ablenkung mittels mehrerer Magnetfelder,
Führen der Primärelektronen durch eine Strahlweiche und eine Objektivlinse, Bestrahlen eines Objekts mit dem energetisch selektierten Elektronenstrahl,
Führen von von dem bestrahlten Objekt ausgehenden Sekundärelektronen in deren Strahlengang zu der Strahlweiche,
Abseparieren der Sekundärelektronen von dem Strahlengang der Primärelektronen in der Strahlweiche, und
Ablenken und/oder Formen des Strahls der abseparierten Sekundärelektronen mit wenigstens einem Strahlablenker bzw. wenigstens einer Quadrupollinse.

8. Verfahren nach Anspruch 7, beinhaltend Fokussieren des Primärelektronenstrahls in einer Objektebene.

9. Verfahren nach Anspruch 7 oder 8, beinhaltend scharfes Abbilden der Objektebene durch die Objektivlinse auf einen Sekundärelektronendetektor.

10. Verfahren nach einem der Ansprüche 7 bis 9, beinhaltend wenigstens teilweises Kompensieren einer Quadrupolwirkung der Strahlweiche auf den Elektronenstrahl mit der wenigstens einen Quadrupollinse.

11. Verfahren nach einem der Ansprüche 7 bis 10, beinhaltend wenigstens teilweises Kompensieren einer Dispersion der Strahlweiche in Bezug auf den Elektronenstrahl mit dem wenigstens einen Strahlablenker.

12. Verfahren nach einem der Ansprüche 7 bis 11, beinhaltend Verwenden des Elektronenmikroskopiesystems nach einem der Ansprüche 1 bis 6.
